# EUROPEAN PATENT APPLICATION

(11) **EP 4 700 416 A1**
(43) Date of publication of application: **25.02.2026**
(21) Application number: 24195359.5
(22) Date of filing: 20.08.2024
(51) Int. Cl.: G01R 31/72, B60T 17/22

(54) **BRAKE RELEASE MECHANISM STATUS CHECK**

(71) Applicant: Goodrich Actuation Systems Limited, Wolverhampton, West Midlands WV10 7EH (GB)
(72) Inventor: BENAROUS, Maamar, Coventry (GB); DERRY, John Alexander, Burton on Trent (GB)
(74) Representative: Casalonga

(57) **Abstract**

A method for determining a status of a solenoid operated mechanism in an aircraft is provided. The method includes generating a solenoid current curve, comparing the generated solenoid current curve with a predetermined current curve that shows movement of an armature, determining if the generated solenoid current curve matches the predetermined current curve that shows movement of the armature, comparing the generated solenoid current curve with a predetermined current curve that shows no movement of an armature, determining if the generated solenoid current curve matches the predetermined current curve that shows no movement of an armature, and outputting a status of the mechanism on the basis of at least one of a) determining if the generated solenoid current curve matches the predetermined current curve that shows movement of the armature and b) determining if the generated solenoid current curve matches the predetermined current curve that shows no movement of an armature.

## Description

### TECHNICAL FIELD

This disclosure relates to methods for determining a status check of a solenoid operated mechanism, for example, as used on wingtip brakes of an aircraft.

### BACKGROUND

Aircrafts rely on brakes which, typically, include a spring-applied solenoid-released device to hold actuation systems in defined positions during both normal operation and after failures. Many units incorporate a mechanism to disengage/engage preloaded spring(s) and a solenoid. On some units, a manual override is also required to operate the mechanism when power is not available, for example for maintenance procedures on the ground. Safety requirements may dictate the need to check the status of the mechanism automatically, which is currently achieved by additional components provided in the mechanism to determine the brake status. However, the additional components provided in the mechanism can be cumbersome to set up, add extra cost and reduce reliability. Therefore, there exists a need for improved methods for determining a status check of a brake release mechanism.

### SUMMARY

In one aspect, there is provided a method for determining a status of a solenoid operated mechanism in an aircraft. The method includes generating a solenoid current curve, comparing the generated solenoid current curve with a predetermined current curve that shows movement of an armature, determining if the generated solenoid current curve matches the predetermined current curve that shows movement of the armature, comparing the generated solenoid current curve with a predetermined current curve that shows no movement of an armature, determining if the generated solenoid current curve matches the predetermined current curve that shows no movement of an armature, and outputting a status of the mechanism on the basis of at least one of a) determining if the generated solenoid current curve matches the predetermined current curve that shows movement of the armature and b) determining if the generated solenoid current curve matches the predetermined current curve that shows no movement of an armature.

The method may further include providing at least one solenoid current profile for a given nominal condition, providing at least one upper and/or lower limit of a solenoid current curve based on the at least one solenoid current profile, wherein the step of generating the solenoid current curve takes into account the at least one upper and/or lower limit of the solenoid current curve.

Additionally, or alternatively, when it is determined that the generated solenoid current curve matched the predetermined current curve that shows movement of the armature, the status that is output may show that the mechanism is disengaged.

Additionally, or alternatively, when it is determined if the generated solenoid current curve matches the predetermined current curve that shows no movement of the armature, the status that is output may show that the mechanism is engaged.

Additionally, or alternatively, when it is determined that there is no match between the generated solenoid current curve and the predetermined current curve that shows no movement of the armature, the status that is output may show that no decision can be made.

In another aspect, there is provided a method for determining a status of a mechanism in an aircraft. The method includes calculating a solenoid coil inductance, comparing the calculated solenoid coil inductance to a predetermined inductance threshold, determining if the calculated solenoid coil inductance is greater than the predetermined inductance threshold, and outputting a status of the mechanism in response to the determination that the calculated solenoid coil inductance is greater than, or below, the predetermined inductance threshold.

Additionally, when it is determined that the calculated solenoid coil inductance is not greater than the predetermined inductance threshold, the status that is output may show that the mechanism is engaged.

Additionally, when it is determined that the calculated solenoid coil inductance is greater than the predetermined inductance threshold, the status that is output may show that the mechanism is released.

Additionally, or alternatively, the status that is output may be one of a visual and/or audible warning.

In a further aspect, there is provided an aircraft. The aircraft includes a solenoid operated mechanism, and a controller configured to perform any of the methods described above to determine the status of the mechanism.

### BRIEF DESCRIPTION OF THE DRAWINGS

Figure 1 shows an example of a brake mechanism.
Figure 2 shows a graph of a solenoid inductance vs. position of an armature.
Figure 3 shows a current curve of a solenoid that represents armature movement.
Figure 4 shows a current curve of a solenoid that represents no armature movement.
Figure 5 shows a method of determining a brake release mechanism status.
Figure 6 shows a method of a pre-flight check of a brake release mechanism status.

### DETAILED DESCRIPTION

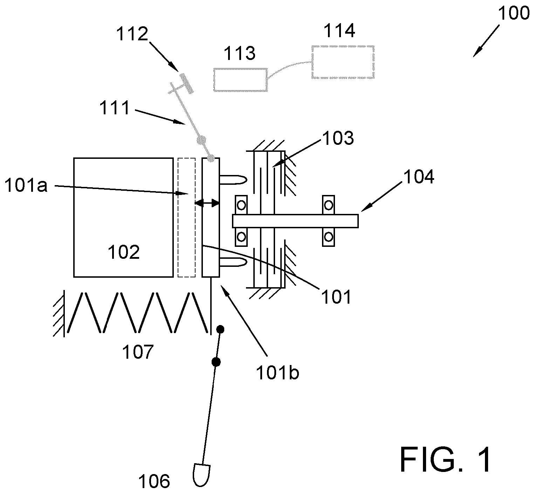

An example of a brake mechanism 100 is shown generally in Figure 1. The brake mechanism 100 includes a solenoid 102, an armature 101 shown in two positions as 101a and 101b, a spring 107, a friction plate pack 103 and a shaft 104. The brake mechanism 100 is engaged by removing power from the solenoid 102 such that armature 101 is provided in the second position 101b. When power is provided to the solenoid 102, the spring 107 compresses and the armature 101 moves from the second position 101b to the first position 101a such that the shaft 104 can be released. It is essential to ensure that the armature 101 is in the correct position before every flight. It is also essential to recognise any faults in the brake mechanism 100, for example, faults on the armature position during flight. In order to do this, the brake mechanism 100 includes a target lever 111 attached to the armature 101, a sensor target 112 provided at one end of the target lever, a proximity sensor 113 in proximity to the sensor target 112 and electronics to determine the position of the sensor target 112 in relation to the proximity sensor 113. As the armature 101 moves, the sensor target 112 moves towards, or away from, the proximity sensor 113 by the movement of the target lever 111. The electronics 114 then determine the distance of the sensor target 112 and utilise these values to determine if the armature 101 is in a 'ready to fly' state or to determine if there is a fault in the position of the armature 101. In addition, there is provided a manual release 106 that can also hold the armature in the released position when there is no power available. These techniques of using a proximity sensor 113 and electronics 114 are expensive and complex to be added to a brake mechanism 100. They are also more difficult to maintain during the lifetime of the aircraft and have proven to be ineffective in their accuracy of determining the position of the armature 101.

The present disclosure aims to overcome the pitfalls of the brake mechanism 100 shown in Figure 1 by providing a method of determining the status of the brake mechanism 100 without the need for additional components such as the proximity sensor 113, sensor target 112, target lever 111 and electronics 114.

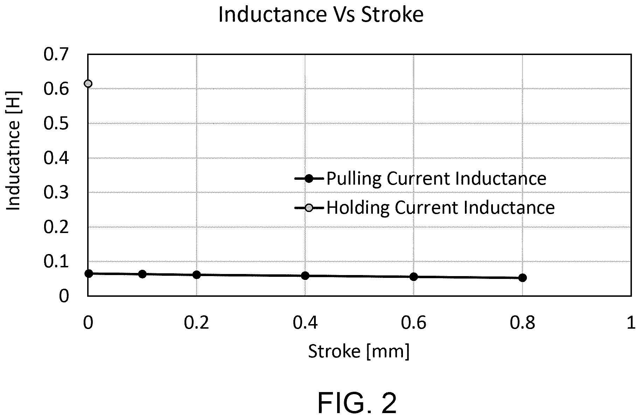

Figure 2 shows a graph of a solenoid inductance vs. position of an armature. As can be seen in Figure 2, the inductance of the solenoid varies with the position of the solenoid armature (e.g. armature 101 as shown in Figure 1). Typically, the solenoid is powered using a closed loop current control drive, with a peak pull in current for a short duration followed by a lower holding current. The graph in Figure 2 shows clearly that a check on the status of the brake can be performed by processing the solenoid inductance. As shown in Figure 2, there is a 20% inductance value difference between the engaged (0.8mm stroke) and the released armature position (0mm stroke) for the same current value, and a 948% difference between the inductance values at the released position with holding current and at the engaged position with pulling current.

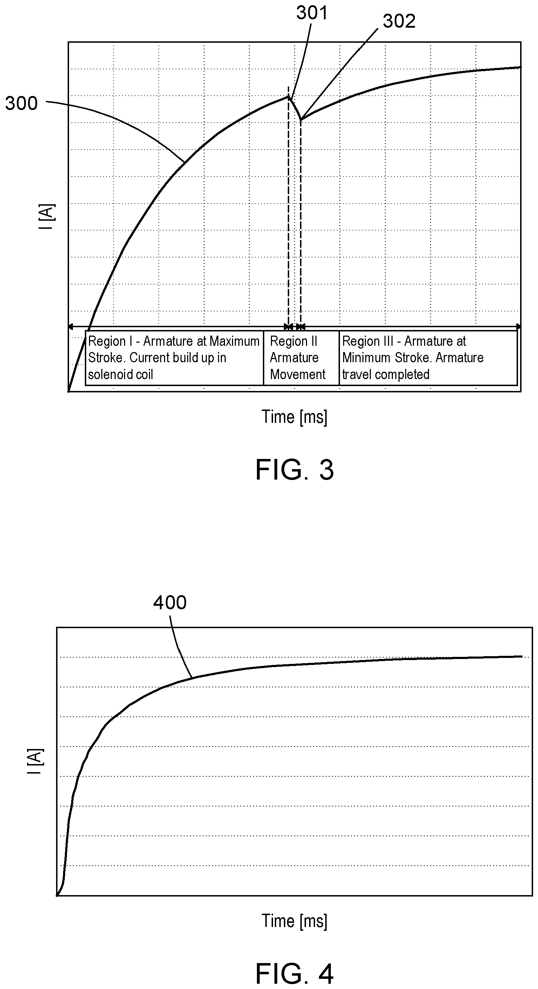

Figure 3 shows a typical solenoid current profile, 300 for the peak pull in current phase of the solenoid operation. Region I shows an area of the curve where the armature is at maximum stroke and shows the build-up of current as voltage is applied to the solenoid. At point 301, the curve moves from Region I to Region II, where Region II represents the current profile during armature movement. At point 302, the curve moves from Region II to Region III, where Region III represents a current profile when the armature is provided at the minimum stroke. The methods described below utilise the current curve 300 in Figure 3 to determine if there has been a fault on the brake mechanism, or if the armature has failed to move during a pre-flight check.

Figure 4 shows a current curve 400 of a solenoid where there has been no armature movement. In comparison to Figure 3, the current curve of Figure 4 clearly does not show three distinct separate regions. The comparison of the current curves 300 and 400 can clearly identify the status of the brake, as will be detailed below with the methods. For example, if following the application of the voltage, the current waveform shape matches the current curve 300 of Figure 3, it can be confirmed that the armature has moved and thus the brake has changed state from engaged to released. However, if the current waveform shape matched the current curve 400 of Figure 4, it can be concluded that the armature has not moved from the 0mm stroke position and that the armature is being held in the brake release position. This could also then indicate to a user of the aircraft, or maintenance teams, that the manual release has not been returned to a flight position.

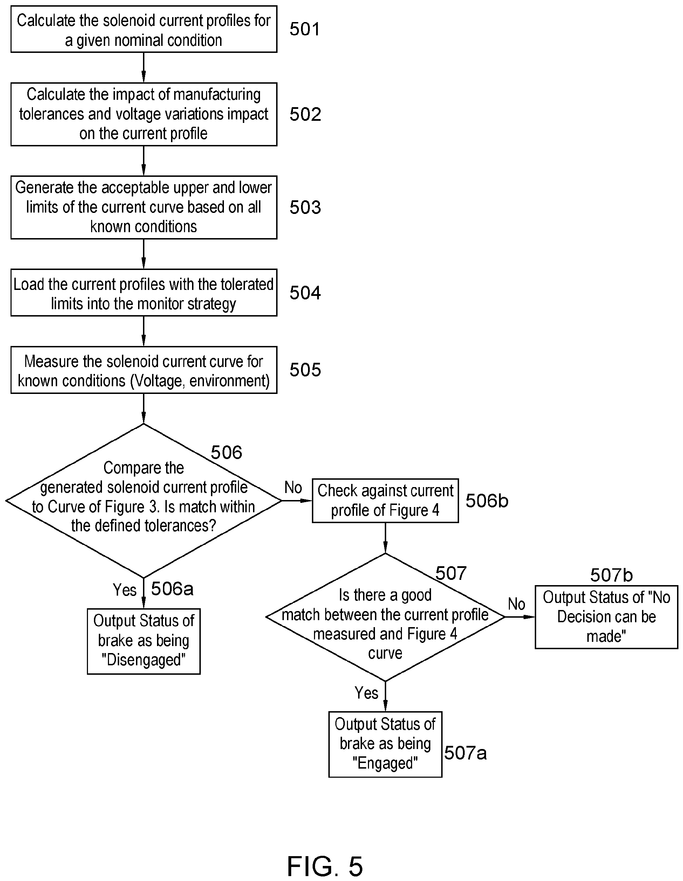

Figure 5 shows a method of determining a brake release mechanism status. At step 501, the solenoid current profiles are provided for a given nominal condition. The impact of manufacturing tolerances and voltage variations on the current profile are also provided at step 502. At step 503, an acceptable upper and/or lower limit of a current curve based on the conditions given by steps 501 and 502 are provided. The acceptable upper and lower limits of the current curve are provided on a case by case basis depending on the design of the mechanism, the mechanical manufacturing tolerances and the effects of the environmental conditions. The current profile with the upper and lower limits can then be loaded to, e.g. a memory for monitoring at step 504. At step 505, a controller (not shown) measures the solenoid current curve for known conditions and generates a solenoid current curve. At step 506, the controller compares the generated solenoid curve to a predetermined current curve that shows armature movement (e.g. the current curve of Figure 3). If it is determined that the generated solenoid current curve matches the predetermined current curve that shows armature movement, an output status is provided that shows that the brake is 'disengaged' at step 506a. If it is determined that the generated solenoid current curve does not match the predetermined current curve that shows armature movement, the controller then checks against a predetermined current curve that shows no armature movement (e.g. the current curve of Figure 4) at step 506b. The controller then compares the generated solenoid current curve with the predetermined current curve that shows no armature movement and determined if there is a good match between the generated solenoid current curve and the predetermined current curve that shows no armature movement at step 507. If it is determined that there is a match between the generated solenoid current curve and the predetermined current curve that shows no armature movement, the controlled outputs a status that indicates that the brake is 'engaged' at step 507a. If it is determined that there is no match between the generated solenoid current curve and the predetermined current curve that shows no armature movement, the controller outputs a status that indicates that 'no decision can be made' to the status of the mechanism at step 507b. When 'no decision can be made' is output, further investigation would then be required by the user of the aircraft or the maintenance team.

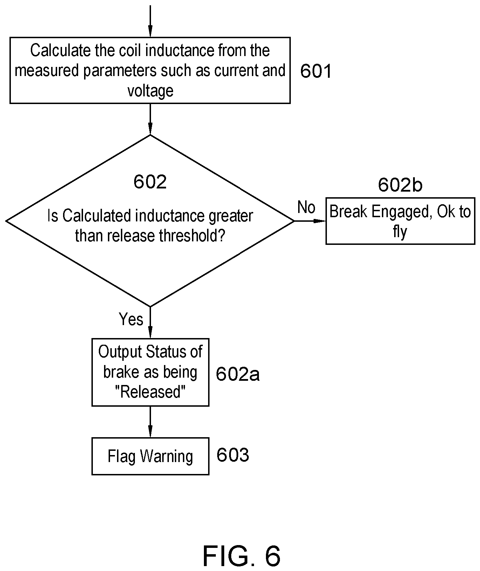

Figure 6 shows an additional, or alternative, method for determining the status of the brake release mechanism, for example, pre-flight. At step 601, a controller calculates the solenoid coil inductance from measured parameters such as current and voltage. At step 602, the controller compares the calculated solenoid coil inductance to a predetermined inductance threshold (e.g. a release threshold). From the comparison, if it is determined that the calculated solenoid coil inductance is not greater than the predetermined inductance threshold, the controller outputs a status that indicates that the brake is 'engaged' and that the aircraft is ready to fly at step 602b. If it is determined that the calculated solenoid coil inductance is greater than the predetermined inductance threshold, the controller outputs a status that indicates that the brake is 'released' at step 602a. This subsequently provides a visual or audible warning to the user or maintenance team at step 603.

With the methods described in conjunction with Figures 5 and 6, the additional components described in Figure 1 would no longer be needed. This then provides a less complex and less expensive brake mechanism status check, and provides a fail-safe status check that is more reliable than using further additional components that have the ability to wear over the lifetime of the aircraft.

Although this disclosure has been described in terms of preferred examples, it should be understood that these examples are illustrative only and that the claims are not limited to those examples. Those skilled in the art will be able to make modifications and alternatives in view of the disclosure which are contemplated as falling within the scope of the appended claims.

## Claims

1. A method for determining a status of a solenoid operated mechanism in an aircraft, the method comprising:
generating a solenoid current curve;
comparing the generated solenoid current curve with a predetermined current curve that shows movement of an armature;
determining if the generated solenoid current curve matches the predetermined current curve that shows movement of the armature;
comparing the generated solenoid current curve with a predetermined current curve that shows no movement of an armature;
determining if the generated solenoid current curve matches the predetermined current curve that shows no movement of an armature; and
outputting a status of the mechanism on the basis of at least one of a) determining if the generated solenoid current curve matches the predetermined current curve that shows movement of the armature and b) determining if the generated solenoid current curve matches the predetermined current curve that shows no movement of an armature.

2. The method of claim 1, wherein the method further comprises:
providing at least one solenoid current profile for a given nominal condition;
providing at least one upper and/or lower limit of a solenoid current curve based on the at least one solenoid current profile;
wherein the step of generating the solenoid current curve takes into account the at least one upper and/or lower limit of the solenoid current curve.

3. The method of claim 1 or 2, wherein, when it is determined that the generated solenoid current curve matched the predetermined current curve that shows movement of the armature, the status that is output shows that the mechanism is disengaged.

4. The method of any preceding claim, wherein, when it is determined if the generated solenoid current curve matches the predetermined current curve that shows no movement of the armature, the status that is output shows that the mechanism is engaged.

5. The method of any preceding claim, wherein, when it is determined that there is no match between the generated solenoid current curve and the predetermined current curve that shows no movement of the armature, the status that is output shows that no decision can be made.

6. A method for determining a status of a mechanism in an aircraft, the method comprising:
calculating a solenoid coil inductance;
comparing the calculated solenoid coil inductance to a predetermined inductance threshold;
determining if the calculated solenoid coil inductance is greater than the predetermined inductance threshold; and
outputting a status of the mechanism in response to the determination that the calculated solenoid coil inductance is greater than, or below, the predetermined inductance threshold.

7. The method of claim 6, wherein, when it is determined that the calculated solenoid coil inductance is not greater than the predetermined inductance threshold, the status that is output shows that the mechanism is engaged.

8. The method of claim 7, wherein, when it is determined that the calculated solenoid coil inductance is greater than the predetermined inductance threshold, the status that is output shows that the mechanism is released.

9. The method of any of claims 6-8, wherein the status that is output is one of a visual and/or audible warning.

10. An aircraft, comprising:
a solenoid operated mechanism; and
a controller configured to perform the method of claims 1 and/or 6 to determine the status of the mechanism.
